# EUROPÄISCHE PATENTSCHRIFT

(11) **EP 3 108 221 B1**
(45) Veröffentlichungstag und Bekanntmachung des Hinweises auf die Patenterteilung: **06.05.2020**
(21) Anmeldenummer: 15700880.6
(22) Anmeldetag: 22.01.2015
(51) Int. Cl.: G01N 21/3504, H01S 5/024, G01N 21/39, H01S 5/34, H01S 5/068, H01S 5/06

(54) **VORRICHTUNG UND VERFAHREN ZUR BESTIMMUNG DER KONZENTRATION ZUMINDEST EINES GASES IN EINEM PROBENGASSTROM MITTELS INFRAROTABSORPTIONSSPEKTROSKOPIE**
DEVICE AND METHOD FOR DETERMINING THE CONCENTRATION OF AT LEAST ONE GAS IN A SAMPLE GAS FLOW BY MEANS OF INFRARED ABSORPTION SPECTROSCOPY
DISPOSITIF ET PROCÉDÉ POUR LA DÉTERMINATION DE LA CONCENTRATION D'AU MOINS UN GAZ DANS UN COURANT DE GAZ ÉCHANTILLON AU MOYEN DE LA SPECTROSCOPIE PAR ABSORPTION INFRAROUGE

(30) Priorität: 18.02.2014 DE 102014102050
(43) Veröffentlichungstag der Anmeldung: 28.12.2016
(73) Patentinhaber: AVL Emission Test Systems GmbH, 41460 Neuss (DE)
(72) Erfinder: FETZNER, Stephan, 76694 Forst (DE); ULMER, Ulrich, 79106 Freiburg (DE)
(74) Vertreter: terpatent Patentanwälte ter Smitten Eberlein-Van Hoof Rütten Daubert
(86) Internationale Anmeldenummer: PCT/EP2015/051202
(87) Internationale Veröffentlichungsnummer: WO 2015/124367

(56) Entgegenhaltungen:
- CN-B- 102 570 289
- CN-U- 201 805 141
- JP-A- 2001 007 433
- JP-A- 2010 258 432
- US-A1- 2007 047 599
- US-A1- 2008 315 102
- US-A1- 2012 287 418
- SLOMAN A W ET AL: "A microcontroller-based driver to stabilize the temperature of an optical stage to within 1 mK in the range , using a Peltier heat pump and a thermistor sensor", MEASUREMENT SCIENCE AND TECHNOLOGY, IOP, BRISTOL, GB, Bd. 7, Nr. 11, November 1996 (1996-11), Seiten 1653-1664, XP020064149, ISSN: 0957-0233, DOI: 10.1088/0957-0233/7/11/015
- DALIANG ZHONG ET AL: "Thermal performance of heatsink and thermoelectric cooler packaging designs in LED", ELECTRONIC PACKAGING TECHNOLOGY&HIGH DENSITY PACKAGING (ICEPT-HDP), 2010 11TH INTERNATIONAL CONFERENCE ON, IEEE, PISCATAWAY, NJ, USA, 16. August 2010 (2010-08-16), Seiten 1377-1381, XP031761179, ISBN: 978-1-4244-8140-8

## Beschreibung

Die Erfindung betrifft eine Vorrichtung zur Bestimmung der Konzentration zumindest eines Gases in einem Probengasstrom mittels Infrarotabsorptionsspektroskopie mit einer Analysezelle und einer Infrarotstrahlungsquelle, deren Strahlung durch die Analysezelle führbar ist, einem Probengasstrom, welcher in die Analysezelle leitbar ist, einem Detektor, über den ein in der Analysezelle entstehendes Absorptionsspektrum messbar ist, einem Kühlkörper und einem Peltier-Kühlelement mit einer warmen Seite und einer kalten Seite, wobei die kalte Seite in wärmeleitendem Kontakt mit der Infrarotstrahlungsquelle oder dem Detektor steht und die warme Seite in wärmeleitendem Kontakt mit dem Kühlkörper steht, sowie ein Verfahren zur Bestimmung der Konzentration zumindest eines Gases in einem Probengasstrom mittels Infrarotabsorptionsspektroskopie mittels einer derartigen Vorrichtung, bei dem eine Strahlung einer Infrarotstrahlungsquelle in eine Analysezelle geleitet wird, die von einem Probengasstrom durchströmt wird, woraufhin mittels eines Detektors ein Absorptionsspektrum der aus der Analysezelle austretenden Strahlung ermittelt wird und in einer Recheneinheit aus dem Absorptionsspektrum die Konzentration eines Gases im Probengasstroms berechnet wird, wobei die Infrarotstrahlungsquelle oder der Detektor mittels eines Peltier-Kühlelementes gekühlt wird.

Die Infrarotspektroskopie ist zur Bestimmung der Konzentration von einzelnen Gaskomponenten bekannt. Die am weitesten verbreiteten Verfahren sind das Fourier Transform Infrarotspektrometer oder der nicht dispersive Infrarotsensor. Mit der Entwicklung von kompakten, leistungsstarken Halbleiterlasern etablieren sich zunehmend Gasanalysatoren auf Basis der Laserspektroskopie. Neue Lasertypen wie Quantenkaskadenlaser revolutionieren die Laserspektroskopie im mittleren Infrarotbereich.

Alle diese Analysemethoden beruhen darauf, dass bei Bestrahlung eines Probengases mit Infrarotstrahlen bestimmte Frequenzbereiche absorbiert werden. Die Infrarotstrahlung liegt dabei in dem Bereich des Schwingungsniveaus von Molekülbindungen, die durch die Absorption zum Schwingen angeregt werden. Voraussetzung hierfür ist ein vorhandenes oder im Molekül erzeugbares Dipolmoment. Die verschiedenen Schwingungszustände verursachen Absorptionsverluste der Infrarotstrahlung unterschiedlicher optischer Frequenzen. Das Spektrum in der Transmission enthält somit einzelne für das Gas charakteristische Absorptionslinien, so dass das Probengas auf das Vorhandensein konkreter Moleküle untersucht und deren Konzentration im Probengas bestimmt werden kann.

Mit einem Quantenkaskadenlaser können insbesondere im Abgas von Verbrennungsmotoren vorhandene Schadstoffmoleküle, wie Distickstoffmonoxid, Stickstoffmonoxid, Stickstoffdioxid, Kohlendioxid, Kohlenmonoxid und Ammoniak ermittelt und deren Konzentration bestimmt werden.

Übliche laserspektroskopische Systeme weisen einen Laser als Strahlungsquelle auf, dessen Strahlung über einen optischen Pfad in eine Analysezelle geleitet wird. In dieser Analysezelle wird der Strahl über eine geeignete Spiegelkonfiguration mehrfach reflektiert. Gleichzeitig wird in diese Analysezelle ein Probengasstrom geleitet, durch den die Strahlung des Lasers dringt und dort für eine Anregung der zur optischen Frequenz korrespondierenden Moleküle sorgt. Durch diese Anregung wird Energie der jeweiligen Frequenz absorbiert. Die Intensität des transmittierten Strahls nimmt an dieser Stelle im Spektrum ab. Die Absorption selbst erfolgt nicht exakt scharf, sondern unterliegt einer Verbreiterung aufgrund von Temperatur- und Druckänderungen. Der auf diese Weise in seinem Spektrum veränderte Strahl verlässt die Messzelle und trifft auf einen Detektor, über den das veränderte Frequenzband ausgewertet wird und so auf das Vorhandensein bestimmter Stoffe und deren Konzentrationen geschlossen werden kann. Die Förderung des Probengasstroms erfolgt üblicherweise über eine nachgeschaltete Vakuumpumpe.

Bei der Bestimmung der Konzentration wird die Absorptionscharakteristik im Spektrum ausgewertet bzw. analysiert. Diese Charakteristik wird im Allgemeinen als Linienspektrum der absorbierenden Gase bezeichnet. Lange Zeit ließen sich Quantenkaskadenlaser lediglich in Temperaturbereichen unter 0°C zuverlässig betrieben. Eine neue Generation von Quantenkaskadenlaser, bei der die Konstruktion des Laserkristalls geändert wurde, und die als Hochtemperaturquantenkaskadenlaser bezeichnet werden, ist zwar auch bei normalen Umgebungstemperatur von 15 bis 40°C betreibbar, jedoch hat es sich gezeigt, dass die aus Halbleiterschichten aufgebauten Quantenkaskadenlaser eine hohe Verlustwärme erzeugen und sich somit im Laufe der Messungen erwärmen. Als einfachste Methode zur zuverlässigen Kühlung der Quantenkaskadenlaser haben sich Peltier-Kühlelemente etabliert, über die versucht wird, den Laser in einem definierten Temperaturbereich zu halten. Wird die entstehende Wärme nicht abgeführt, so dass eine Änderung der Betriebstemperatur des Lasers während der Messung erfolgt, so führt dies zu einer Änderung der notwendigen Abstimmwellenlänge und daraus folgend zu ungenauen Messergebnissen aufgrund der mit der Temperatur zunehmenden thermischen Bewegung der Ladungsträger. Aus diesem Grund sollten die Temperaturschwankungen des Quantenkaskadenlasers idealerweise auf +-5mK reduziert werden.

So wird in der US 2011/0173870 A1 ein Aufbau eines Quantenkaskadenlasers beschrieben, der auf einer als Wärmesenke dienenden Metallplatte montiert ist, deren entgegengesetzte Seite mit der kalten Seite eines Peltier-Kühlelementes verbunden ist, so dass über die Metallplatte Wärme aus dem Laser abgeführt werden kann. Zur Regelung ist am Verstärkungsmedium des Lasers ein Temperatursensor angeordnet, über den die Temperatur des Lasers gemessen und geregelt wird. Die Regelung erfolgt über Änderung der Laserleistung oder der elektrischen Leistung, die dem Peltier-Element zugeführt wird.

Nachteilhaft an einer derartigen Regelung ist es jedoch, dass sich kein stationärer Zustand einstellen kann, da die warme Seite des Peltier-Kühlelementes den Schwankungen der Umgebungstemperatur ausgesetzt ist, so dass ein ständiges Nachregeln erforderlich wird. Dies führt dazu, dass die Temperaturschwankungen häufig größer sind als gefordert und somit ein Rauschen im Detektorsignal vorhanden ist.

Ein weiterer Quantenkaskadenlaser in einer Anordnung zur Infrarotabsorptionsspektroskopie von Gasen ist aus der US 2008/0315102 A1 bekannt. Dieser Quantenkaskadenlaser weist zwei Detektoren auf, welche wie auch die Strahlungsquelle thermoelektrisch gekühlt werden.

Die Druckschrift CN 102 570 289 B offenbart eine Laserdiode, die von einem thermoelektrischen Kühler gekühlt wird, dessen warme Seite mit einer wassergekühlten Wärmesenke in wärmeleitendem Kontakt steht. Eine Wasserpumpe führt das Kühlwasser zu einem Wärmetauscher, der von einem drehzahlgeregelten Ventilator gekühlt wird.

Die Druckschrift JP 2001 007433 A offenbart eine Laserdiode, die von einem thermoelektrischen Kühler gekühlt wird, dessen warme Seite mit einem Kühlkörper in wärmeleitendem Kontakt steht, der wiederum von einem Lüfter gekühlt wird, der eine Drehzahlsteuerung hat, um den Stromverbrauch zu reduzieren.

Daher stellt sich die Aufgabe, eine Vorrichtung und ein Verfahren zur Bestimmung der Konzentration zumindest eines Gases in einem Probengasstrom mittels Infrarotabsorption zu schaffen, mit der die Messergebnisse im Vergleich zu bekannten Ausführungen weiter verbessert werden, indem Temperaturschwankungen am Quantenkaskadenlaser minimiert werden. Die Regelungen und Messungen sollen dabei möglichst einfach und kostengünstig herstellbar sein.

Diese Aufgabe wird durch eine Vorrichtung zur Bestimmung der Konzentration zumindest eines Gases in einem Probengasstrom mittels Infrarotabsorptionsspektroskopie mit den Merkmalen des Hauptanspruchs 1 sowie durch ein Verfahren mit einer derartigen Vorrichtung gemäß Hauptanspruch 15 gelöst. Die vorliegende Erfindung ist in den Ansprüchen 1 und 15 definiert.

Dadurch, dass die Vorrichtung einen drehzahlgeregelten Lüfter aufweist, mittels dessen der Kühlkörper gekühlt ist, kann auch die Temperatur an der warmen Seite des Peltier-Kühlelementes und somit auch die Temperatur an der kalten Seite des Peltier-Kühlelementes bei konstanter Verlustleistung des Lasers konstant gehalten werden, da eine Unabhängigkeit von der Umgebungstemperatur, also der Temperatur mit der die Wärme des Peltier-Kühlelementes abgeführt wird, erreicht wird. Die Kühlwirkung durch den Lüfter kann so im Wesentlichen konstant gehalten werden, indem bei steigernder Umgebungstemperatur die Drehzahl erhöht wird.

Bezüglich des erfindungsgemäßen Verfahrens wird somit die warme Seite des Peltier-Kühlelementes mittels eines drehzahlgeregelten Lüfters zumindest indirekt gekühlt. Diese Kühlung kann theoretisch direkt erfolgen, wird jedoch üblicherweise über wärmeleitend verbundene Kühlkörper durchgeführt. Wesentlich ist, dass durch die Drehzahlregelung des Lüfters die Wärmeabführung ohne Änderung der Leistung des Peltier-Kühlelementes geregelt werden kann.

Dabei erfolgt die Drehzahlregelung des Lüfters vorzugsweise mittels Pulsweitenmodulation. Die Drehzahl des Lüfters wird entsprechend durch Änderung eines Pulsweitenmodulations-Signals geregelt. Diese Regelung ist einfach in der Steuerung implementierbar und reduziert den Stromverbrauch.

In einer vorteilhaften Ausführungsform ist die Infrarotstrahlungsquelle auf einer Metallplatte angeordnet, die mit der kalten Seite des Peltier-Kühlelementes wärmeleitend verbunden ist. So wird ein guter Wärmeübergang sichergestellt, wobei gleichzeitig eine zuverlässige Befestigung des Lasers, beispielsweise durch Verschrauben auf der Metallplatte möglich ist. Auch kann diese Platte mit entsprechenden Halterungen für den Laser ausgeführt werden. Des Weiteren wird eine vollständige flächige Auflage auf dem Peltier-Kühlelement sichergestellt, die zu korrekten Verwendung notwendig ist.

Vorzugsweise misst ein Temperatursensor eine Temperatur, welche im Wesentlichen der Temperatur der warmen Seite des Peltier-Kühlelementes entspricht, wobei der Temperatursensor mit einer elektronischen Recheneinheit des Lüfters elektrisch verbunden ist. Entsprechend erfolgt die Regelung in Abhängigkeit der Temperatur an der warmen Seite des Peltier-Kühlelementes, die durch Regelung des Lüfters konstant gehalten werden kann.

Zusätzlich misst ein weiterer Temperatursensor eine Temperatur, welche im Wesentlichen der Temperatur der kalten Seite des Peltier-Kühlelementes entspricht, wobei der Temperatursensor mit einer elektronischen Regeleinheit des Peltier-Kühlelementes elektrisch verbunden ist. Durch Anpassung der Stromstärke wird so eine konstante Temperatur am Laserchip erzeugt. Diese Regelung erfolgt in sehr engen Grenzen, da die warme Seite mittels des Lüfters auf konstanter Temperatur gehalten wird. Durch diese zweistufige Regelung sind sehr kleine Temperaturabweichungen erreichbar.

Die Infrarotstrahlungsquelle weist einen Laserchip auf, der vorteilhafterweise mittels einer Halterung befestigt ist und in wärmeleitendem Kontakt mit der Metallplatte steht. Dies vereinfacht die Montage des Lasers.

Dabei ist die Metallplatte vorzugsweise eine Kupferplatte, da Kupfer eine sehr gute Wärmeleitfähigkeit besitzt, so dass die Wärme aus dem Halbleiterchip gut abführbar ist.

In einer weitergehenden Ausführungsform weist der Kühlkörper an seiner vom Peltier-Kühlelement abgewandten Unterseite Rippen auf, durch die die Wärmeaustauschfläche vergrößert wird, so dass mehr Wärme durch den Luftstrom abgeführt werden kann.

In einer besonders bevorzugten Ausführung sind die optischen Elemente außerhalb der Analysezelle auf einer Optikplatte angeordnet, die wärmeleitend zwischen dem Kühlkörper und der warmen Seite des Peltier-Kühlelementes angeordnet ist. Entsprechend kann der gesamte Strahlengang zur Verringerung des Wärmerauschens auf einer weitestgehend konstanten Temperatur gehalten werden.

Bei dieser Ausführung misst der Temperatursensor die Temperatur auf der Oberseite der Optikplatte in unmittelbarer Nähe zum Peltier-Kühlelement. Diese Temperatur entspricht im Wesentlichen der Temperatur der warmen Seite des Peltier-Kühlelementes aufgrund der direkten wärmeleitenden Anbindung. Gleichzeitig wird sichergestellt, dass die Optikplatte auf einer konstanten Temperatur gehalten werden kann, ohne dass dies die Regelung der Temperatur der warmen Seite des Peltier-Kühlelementes beeinflusst. Der Temperatursensor ist an der Optikplatte einfach montierbar.

Vorzugsweise weist die Vorrichtung ein Gehäuse auf, aus dessen Umgebung der Lüfter Umgebungsluft ansaugt. Im Gehäuse sind Leitkörper angeordnet, welche den Luftstrom zur Unterseite des Kühlkörpers leiten. Die Kühlung wird somit mit Umgebungsluft von der Außenseite des Analysators durchgeführt. Es müssen keine zusätzlichen Kühlelemente vorgesehen werden.

Um Verletzungen durch ein Eingreifen des Bedienpersonals in den Bereich des sich drehenden Lüfterrades zu verhindern sowie zur Verbesserung der elektromagnetischen Verträglichkeit, sind am Gehäuse an einer ersten Seitenwand Lufteinlassschlitze und an einer gegenüberliegenden Seitenwand Luftauslassschlitze ausgebildet, wobei sich die Lufteinlassschlitze im Wesentlichen über den Umfang des Lüfters erstrecken und die Luftauslassschlitze sich zwischen einem Boden des Gehäuses und der Unterseite des Kühlkörpers erstrecken. Dies führt dazu, dass der kühlende Luftstrom entlang der gesamten Optikplatte geleitet wird. So werden Temperaturgradienten innerhalb des Gehäuses im Bereich der Optikplatte weitestgehend vermieden.

Um eine möglichst gute Wärmeleitung zwischen den verschiedenen Bauteilen sicher zu stellen, sind zwei oder mehrere der Bauteile Kühlkörper, Optikplatte, Peltier-Kühlelement, Metallplatte mittels einer Wärmeleitpaste miteinander verbunden. Dieser sorgt dafür, dass die Wärmeleitung über den Spalt weitestgehend verlustfrei erfolgt, so dass beispielsweise die warme Seite des Peltier-Kühlelementes und die Optikplatte eine im Wesentlichen gleiche Temperatur aufweisen, dass heißt eine gleiche Wärmemenge aus beiden Teilen abführbar ist.

Vorteilhafterweise ist die Infrarotstrahlungsquelle ein Quantenkaskadenlaser, der im mittleren Infrarotbereich besonders gute Messergebnisse liefert.

Bezüglich des Verfahrens ist es somit vorteilhaft, wenn mittels des Lüfters Umgebungsluft entlang des Kühlkörpers gefördert wird. Es müssen somit keine zusätzlichen Vorkehrungen zur Kühlung getroffen werden, so dass der Analysator kostengünstig herzustellen und zu betreiben ist.

Besonders bevorzugt ist es, wenn der Kühlkörper auf einen konstanten Wert zwischen 30°C und 50°C geregelt wird, insbesondere auf 40°C geregelt wird. Diese erhöhte Betriebstemperatur im Vergleich zur üblichen Betriebstemperatur stellt sicher, dass über den mit Umgebungsluft betriebenen Lüfter immer genug Wärme abgeführt werden kann, um eine konstante Betriebstemperatur herzustellen. Zusätzlich funktioniert diese Regelung auch zuverlässig bei Änderung der Umgebungstemperatur.

In einer hierzu weiterführenden Ausführungsform ist die Bestromung des Peltier-Kühlelementes konstant. Da der Laser nach dem Anschalten eine konstante Wärmemenge abgibt und andererseits eine gleiche Wärmemenge über den drehzahlgeregelten Lüfter abgeführt werden kann, wird es möglich diese konstante Bestromung des Peltier-Kühlelementes zu nutzen, wodurch der Regelkreis sehr einfach wird.

Dabei wird die Bestromung des Peltier-Kühlelementes vorzugsweise so eingestellt, dass zwischen den Platten des Peltier-Kühlelementes eine konstante Temperaturdifferenz von 20 bis 40K anliegt, was ebenfalls durch die insgesamt konstanten sonstigen Betriebsbedingungen ermöglicht wird. Insgesamt ergibt sich somit eine einfache Regelung, um eine konstante Temperatur des Lasers herzustellen.

Es wird somit eine Vorrichtung und ein Verfahren zur Bestimmung der Konzentration eines Gases in einem Probengasstrom mittels Infrarotabsorptionsspektroskopie geschaffen, mit der die Konzentration und Anwesenheit eines Gases mit hoher Genauigkeit und Reproduzierbarkeit und weitestgehend ohne Wärmerauschen festgestellt werden kann, da gleichbleibende Randbedingungen mit Temperaturschwankungen von unter +-5mK erreicht werden. Gleichzeitig ist ein Laser mit einer solchen Regelung im Vergleich zu bekannten Ausführungen einfach und kostengünstig herstellbar und montierbar.

Ein Ausführungsbeispiel einer erfindungsgemäßen Vorrichtung zur Bestimmung der Konzentration zumindest eines Gases in einem Probengasstrom mittels Infrarotabsorptionsspektroskopie ist in den Figuren anhand eines Quantenkaskadenlasers dargestellt und wird nachfolgend in Zusammenhang mit dem erfindungsgemäßen Verfahren beschrieben.

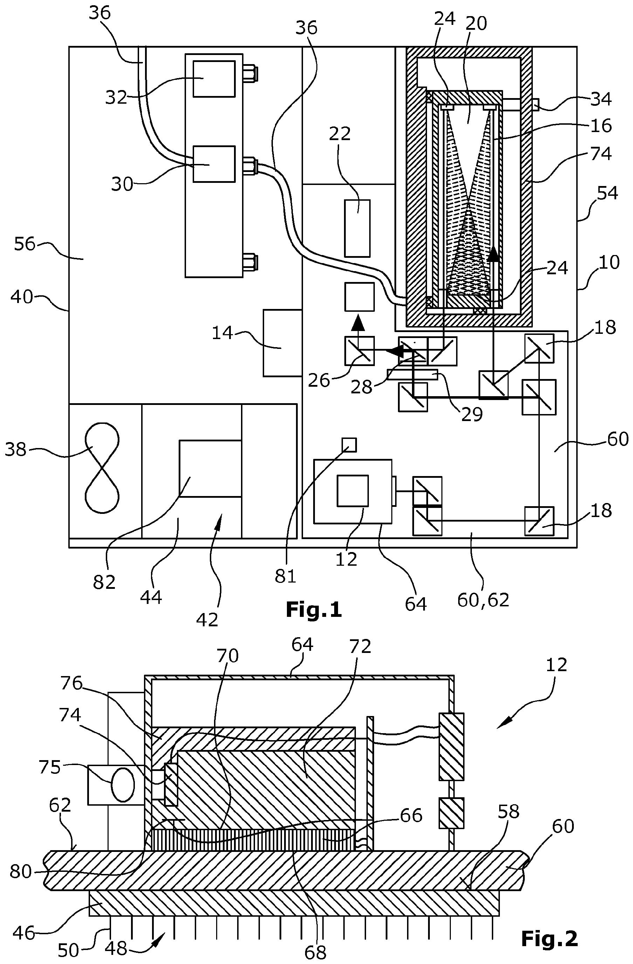

Die Figur 1 zeigt eine schematische Darstellung einer erfindungsgemäßen Vorrichtung zur Bestimmung der Konzentration eines Gases in einem Probengasstrom in Draufsicht.

Die Figur 2 zeigt eine schematische Darstellung des Aufbaus eines Quantenkaskadenlasers mit den angebundenen Bauteilen in Seitenansicht.

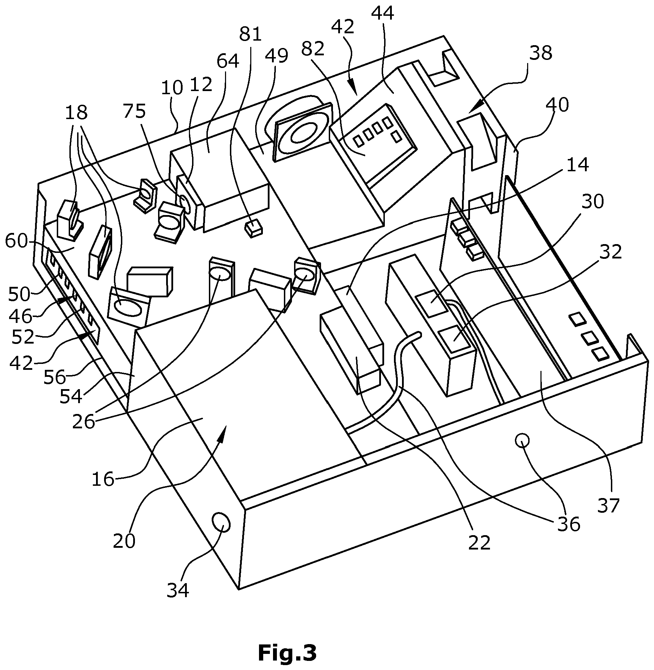

Die Figur 3 zeigt eine perspektivische Darstellung der Vorrichtung gemäß Figur 1.

Die erfindungsgemäße Vorrichtung zur Bestimmung der Konzentration zumindest eines Gases in einem Probengasstrom mittels Infrarotabsorptionsspektroskopie ist im vorliegenden Ausführungsbeispiel als Quantenkaskadenlaserabsorptionsspektrometer ausgeführt. Dieser besteht aus einem Gehäuse 10, in dem ein aus Halbleiterschichten aufgebauter Quantenkaskadenlaser 12 als Infrarotstrahlungsquelle angeordnet ist, der entweder kontinuierlich oder gepulst betrieben werden kann und insbesondere im mittleren Infrarotbereich Strahlung emittiert. Dieser wird über einen Stromtreiber 14 angesteuert.

Der Strahl des Lasers 12 wird über mehrere Spiegel 18 in einen Raum 20 einer Analysezelle 16 oder alternativ über die Spiegel 18 direkt zu einem Detektor 22 geleitet, welcher beispielsweise ein MCT (Quecksilber-Cadmium-Tellurid)-Detektor sein kann, der besonders für die photovoltaische Detektion im mittleren Infrarotbereich geeignet ist und bei dem ein auftreffender Lichtquant direkt in einen messbaren Photostrom umgesetzt wird. Im Raum 20 wird dieser Strahl mehrfach an Objekt- oder Feldspiegeln 24 reflektiert und durchdringt dabei ein in den Raum 20 gefördertes Probengas. Dies führt in bestimmten Frequenzbereichen des gesendeten Lichtbandes zu einer Absorption des Strahls, welche charakteristisch für die Anwesenheit und Konzentration bestimmter Moleküle ist. Nachdem der Strahl mehrfach an den Objekt- oder Feldspiegeln 24 reflektiert wurde, verlässt er die Analysezelle 16 wieder und wird erneut über folgende Spiegel 26 dem Detektor 22 zugeführt.

Einer dieser Spiegel ist als Klappspiegel 28 ausgeführt, so dass je nach dessen Stellung entweder ein als Referenzlaserstrahl dienender Laserstrahl des Quantenkaskadenlasers 12 über eine Referenzgasquelle beziehungsweise Referenzgasküvette 29 zum Detektor 22 gelangt oder wie beschrieben der durch die Analysezelle 16 geführte Laserstrahl.

Die Probengasförderung erfolgt mittels einer Vakuumpumpe 30, mittels derer der Probengasstrom in den Raum 20 gesaugt wird. Der gesamte Strahlengang wird mit einem Gas, welches keine Moleküle des zu messenden Gases enthält, üblicherweise mit Stickstoff, gespült, um eine Verfälschung der Messergebnisse zu vermeiden.

An der Analysezelle 16 ist ein Probengaseinlassstutzen 34 ausgebildet, der über einen nicht dargestellten Schlauch mit einer Probengasquelle, wie beispielsweise einem Abgaskanal eines Verbrennungsmotors verbunden wird oder mit einer bereits verdünntes Probengas enthaltenden Quelle verbunden wird. Über die Vakuumpumpe 30 wird so das Probengas aus dem Einlassstutzen 34 über einen Probengaskanal 36 und den Raum 20 zur Vakuumpumpe 30 gesaugt.

Das vom Detektor 22 gemessene optische Frequenzband weist durch die absorbierte Strahlung Lücken auf, deren Größe und Tiefe ein Maß für die Konzentration des diesen Frequenzbereich absorbierenden Gases ist. Die entsprechende Umrechnung erfolgt in bekannter Weise in einer Recheneinheit 37 über das Lambert-Beer-Gesetz. Die ausgesendete Wellenlänge des Lasers 12 kann dabei so eingestellt werden, dass selektiv der Absorptionsbereich einer bestimmten Absorptionslinie der Gaskomponente abgefahren werden kann, wodurch Querempfindlichkeiten zu anderen Gaskomponenten vermieden werden. So treten bei der Anwesenheit von Ammoniak beispielsweise Lücken im Wellenlängenbereich von etwa 10 µm auf.

Zu beachten ist jedoch, dass eine zuverlässige Messung nur bei einer korrekten Abstimmung zwischen der Weglänge des Strahls und der zu erwartenden Konzentration des zu messenden Moleküls im Probengasstrom möglich ist, so dass entweder mit einem unverdünnten oder einem verdünnten Probengasstrom gearbeitet werden muss. Zusätzlich müssen die Messbedingungen konstant gehalten werden.

Insbesondere ist es erforderlich, den Quantenkaskadenlaser 12 und/oder den Detektor 22 mit stabilen Temperaturen zu betreiben, um ein Wärmerauschen durch Temperaturschwankungen zu verhindern.

Dies wird erfindungsgemäß durch einen drehzahlgeregelten Lüfter 38 erreicht. Dieser Lüfter 38 ist an einer ersten Seitenwand 40 des Gehäuses 10 angeordnet und saugt über nicht erkennbare Lufteinlassschlitze in dieser Seitenwand 40 Umgebungsluft in einen Tunnel 42 an, der durch Leitkörper 44 in Form von Blechwänden begrenzt wird. Der Tunnel 42 verringert sich in seiner Höhe und mündet unter einem Kühlkörper 46, entlang dessen Unterseite 48 die vom Lüfter angesaugte zur Kühlung dienende Umgebungsluft strömt. Um eine größere Wärmeaustauschfläche zur Verfügung zu stellen, sind an der Unterseite 48 des Kühlkörpers 46 Rippen 50 ausgebildet, die sich in Strömungsrichtung erstrecken. Die Luft verlässt das Gehäuse 10 durch Luftauslassschlitze 52, die in einer zur ersten Seitenwand 40 gegenüberliegenden Seitenwand 54 ausgebildet sind und sich vom Boden 56 des Gehäuses bis zur Unterseite 48 des Kühlkörpers 46 erstrecken.

Der Kühlkörper 46 ist vollflächig auf einer an seiner Oberseite 58 angeordneten Optikplatte 60 befestigt, so dass eine gute Wärmeabführung von der Optikplatte 60 in Richtung des Kühlkörpers 46 ermöglicht wird. Die Optikplatte 60 dient als Träger der optischen Elemente, die aus den Spiegeln 18, 24, 26, 28 dem Detektor 22 und dem Quantenkaskadenlaser 12 bestehen, welche auf einer Oberseite 62 der Optikplatte 60 befestigt sind.

Auf der Optikplatte 60 ist ein Lasergehäuse 64 mittels Schrauben befestigt. Die Unterseite des Lasergehäuses 64 bildet ein Peltier-Kühlelement 66, welches derart befestigt ist, dass seine warme Seite 68 vollflächig auf der Optikplatte 60 befestigt ist und seine kalte Seite 70 vollflächig auf einem Kupferblock 72 befestigt ist. Um die Wärmeleitung zwischen dem Peltier-Kühlelement 66, der Optikplatte 60 und des Kupferblocks 72 zu optimieren, erfolgt die Befestigung vorzugsweise mittels einer dünnflächigen Verklebung mit einer Wärmeleitpaste. Ein Laserchip 74 des Quantenkaskadenlasers 12 ist über eine Halterung 76 auf dem Kupferblock 72 befestigt. Die übrigen optischen Laserelemente, wie die Kollimationslinse 75 sind in bekannter Weise im Lasergehäuse 64 angeordnet. Aus dem Lasergehäuse 64 ragen elektrische Anschlusskontakte, über die der Laserchip 74 und das Peltier-Kühlelement 66 mit Strom versorgt werden. Die Regelung erfolgt in bekannter Weise mittels einer elektronischen Regeleinheit 82, die auf dem Leitkörper 44 angeordnet ist.

Bei Inbetriebnahme wird der Laserchip 74 zunächst mit einem Strom in Rampenform zwischen 0 mA und etwa 400mA versorgt, so dass ein Lichtstrahl entlang eines bestimmten Frequenzspektrums erzeugt wird. Die resultierende Verlustleistung ist bei gleichbleibenden Randbedingungen im Wesentlichen konstant. Um die entstehende Wärme abzuführen, wird auch das Peltier-Kühlelement 66 mit einer Gleichspannung versorgt. Bei 24 Volt Gleichspannung und einem Strom von 0,5A entsteht beispielsweise eine Temperaturdifferenz zwischen der warmen Seite 68 und der kalten Seite 70 des Peltier-Kühlelementes 66 von ca. 30 Kelvin. Die Regelung erfolgt nun so, dass die über einen Temperatursensor 80, der im Lasergehäuse 64 nahe am Laserchip 74 montiert ist, ermittelte Temperatur, die somit der Temperatur an der kalten Seite 70 des Peltier-Elementes im Wesentlichen entspricht, über die Regeleinheit 82 durch Regelung der Stromstärke am Peltier-Kühlelement 66 auf beispielsweise 11°C geregelt wird. Der Temperatursensors 80 ist hierfür beispielsweise als Pt100 ausgeführt.

Um nun möglichst kleine Temperaturänderungen im Bereich von +-5mK am Laserchip 74 sicher stellen zu können, reicht eine Regelung, welche lediglich über die Stromstärke des Peltier-Kühlelementes 66 erfolgt, häufig nicht aus. Aus diesem Grunde wird in unmittelbarer Nähe zum Lasergehäuse 64 auf der Optikplatte 60 ein zusätzlicher Temperatursensor 81 angeordnet, dessen gemessene Temperatur aufgrund der guten wärmeleitenden Anbindung im Wesentlichen der Temperatur auf der warmen Seite des Peltier-Kühlelementes 66 entspricht. Die Messwerte des Temperatursensors 81 werden der elektronischen Recheneinheit 37 zur Verfügung gestellt, über welche auch die Drehzahl des Lüfters 38 durch Änderung der modulierten Pulsweiten, mit denen er angesteuert wird, regelbar ist.

Um die konstante Lasertemperatur von beispielsweise 11°C zu erhalten, die durch die vollflächige Anbindung an dem Kupferblock 72 und deren wärmeleitenden Anbindung an der kalten Seite 70 des Peltier-Kühlelementes 66 der Temperatur an der kalten Seite 70 des Peltier-Kühlelementes 66 im Wesentlichen entspricht, wird die Temperatur an der warmen Seite 68 des Peltier-Kühlelementes 66 mit Hilfe des Temperatursensors 81 beispielsweise auf konstant 40°C gehalten. Dementsprechend wird durch die Bestromung des Peltier-Kühlelementes 66 eine möglichst konstante Temperaturdifferenz von 29 Kelvin eingestellt. Diese Temperatur von 40°C liegt durch die vollflächige Anbindung der warmen Seite 68 des Peltier-Elementes 66 an der Optikplatte 60 und deren wärmeleitenden Anbindung am Kühlkörper 46 auch am Kühlkörper 46 und der Optikplatte 60 zumindest im Bereich neben dem Peltier-Kühlelement 66 an und entspricht der an der Oberfläche der Optikplatte 60 neben dem Peltier-Kühlelement 66 mittels des Temperatursensors 81 gemessenen Temperatur. Diese Temperatur ist im Vergleich zu bekannten Regelungen höher, jedoch ergibt sich durch dieses Erhöhen der Betriebstemperatur auf der warmen Seite 68 die Möglichkeit, die Temperatur an dieser Stelle durch Einstellen der Wärmeabfuhr am Kühlkörper 46 alleine durch den Luftstrom am Kühlkörper 46 konstant zu halten, da der die Wärmeabfuhr erzeugende Luftstrom vollständig durch Drehzahlregelung des Lüfters 38 gesteuert werden kann. Entsprechend ist es möglich, beinahe stationäre Temperaturverhältnisse zu schaffen, die dazu führen, dass die Temperatur des Lasers 12 im Bereich von lediglich +-5mK variiert.

Dies bedeutet, dass im Vergleich zu bekannten Ausführungen ein Nachregeln des Peltier-Elementes wegen Erwärmung der Umgebungsluft und einer daraus folgenden Erwärmung der warmen Seite des Peltier-Elementes nur noch in sehr engen Grenzen erforderlich ist. Die Temperaturregelung des Lasers wird somit stabiler, wodurch ein Wärmerauschen verringert wird. Dies wiederum führt zu einer höheren Genauigkeit bei der Messung der absorbierten Strahlung und somit bei der Bestimmung der Konzentrationen der Gase.

Es sollte deutlich sein, dass die vorliegende Erfindung nicht auf das beschriebene Ausführungsbeispiel beschränkt ist, sondern verschiedene Modifikationen innerhalb des Schutzbereichs des vorliegenden Hauptanspruchs möglich sind. Diese Vorrichtung eignet sich in besonderer Weise für die Verwendung bei Quantenkaskadenlasern. Neben der Pulsweitenmodulation sind selbstverständlich auch andere Steuerungen des Lüfters zur Regelung denkbar. Auch ist es denkbar, diese Temperaturregelung für den Detektor zu nutzen.

## Patentansprüche

1. Vorrichtung zur Bestimmung der Konzentration zumindest eines Gases in einem Probengasstrom mittels Infrarotabsorptionsspektroskopie mit
einer Analysezelle (16) und einer Infrarotstrahlungsquelle (12), deren Strahlung durch die Analysezelle (16) führbar ist, einer Vorrichtung, durch die ein Probengasstrom in die Analysezelle (16) leitbar ist, einem Detektor (22), über den ein in der Analysezelle (16) entstehendes Absorptionsspektrum messbar ist,
einem Kühlkörper (46) und einem Peltier-Kühlelement (66) mit einer warmen Seite (68) und einer kalten Seite (70), wobei die kalte Seite (70) in wärmeleitendem Kontakt mit der Infrarotstrahlungsquelle (12) oder dem Detektor (22) steht und die warme Seite in wärmeleitendem Kontakt mit dem Kühlkörper (46) steht,
**dadurch gekennzeichnet, dass**
die Vorrichtung einen drehzahlgeregelten Lüfter (38) aufweist, mittels dessen der Kühlkörper (46) gekühlt ist.

2. Vorrichtung zur Bestimmung der Konzentration zumindest eines Gases in einem Probengasstrom mittels Infrarotabsorptionsspektroskopie nach Anspruch 1,
**dadurch gekennzeichnet, dass**
die Drehzahlregelung des Lüfters (38) mittels Pulsweitenmodulation erfolgt.

3. Vorrichtung zur Bestimmung der Konzentration zumindest eines Gases in einem Probengasstrom mittels Infrarotabsorptionsspektroskopie nach einem der Ansprüche 1 oder 2,
**dadurch gekennzeichnet, dass**
die Infrarotstrahlungsquelle (12) auf einer Metallplatte (72) angeordnet ist, die mit der kalten Seite (70) des Peltier-Kühlelementes (66) wärmeleitend verbunden ist.

4. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
ein Temperatursensor (81), der angeordnet ist, eine Temperatur zu messen, welche im Wesentlichen der Temperatur der warmen Seite (68) des Peltier-Kühlelementes (66) entspricht, wobei der Temperatursensor (81) mit einer elektronischen Recheneinheit (37) des Lüfters (38) elektrisch verbunden ist.

5. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
ein weiterer Temperatursensor (80), der angeordnet ist, eine Temperatur zu messen, welche im Wesentlichen der Temperatur der kalten Seite (70) des Peltier-Kühlelementes (66) entspricht, wobei der Temperatursensor (80) mit einer elektronischen Regeleinheit (82) des Peltier-Kühlelementes (66) elektrisch verbunden ist.

6. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
die Infrarotstrahlungsquelle (12) einen Laserchip (74) aufweist, der mittels einer Halterung (76) befestigt ist und in wärmeleitendem Kontakt mit der Metallplatte (72) steht.

7. Vorrichtung zur Bestimmung der Konzentration zumindest eines Gases in einem Probengasstrom mittels Infrarotabsorptionsspektroskopie nach einem der Ansprüche 3 bis 6,
**dadurch gekennzeichnet, dass**
die Metallplatte (72) ein Kupferblock ist.

8. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
der Kühlkörper (46) an seiner vom Peltier-Kühlelement (66) abgewandten Unterseite (48) Rippen (50) aufweist.

9. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
die optischen Elemente (12, 18, 22, 24, 26, 28) außerhalb der Analysezelle (16) auf einer Optikplatte (60) angeordnet sind, die wärmeleitend zwischen dem Kühlkörper (46) und der warmen Seite (68) des Peltier-Kühlelementes (66) angeordnet ist.

10. Vorrichtung zur Bestimmung der Konzentration zumindest eines Gases in einem Probengasstrom mittels Infrarotabsorptionsspektroskopie nach Anspruch 9,
**dadurch gekennzeichnet, dass**
der Temperatursensor (81) angeordnet ist, die Temperatur auf der Oberseite (62) der Optikplatte (60) in unmittelbarer Nähe zum Peltier-Kühlelement (66) zu messen.

11. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
die Vorrichtung ein Gehäuse (10) aufweist, das es dem Lüfter (38) ermöglicht, aus dessen Umgebung Umgebungsluft anzusaugen und im Gehäuse (10) Leitkörper (44) angeordnet sind, welche dazu ausgebildet sind, den Luftstrom zur Unterseite (48) des Kühlkörpers (46) zu leiten.

12. Vorrichtung zur Bestimmung der Konzentration zumindest eines Gases in einem Probengasstrom mittels Infrarotabsorptionsspektroskopie nach Anspruch 11,
**dadurch gekennzeichnet, dass**
am Gehäuse (10) an einer ersten Seitenwand (40) Lufteinlassschlitze und an einer gegenüberliegenden Seitenwand (54) Luftauslassschlitze (52) ausgebildet sind, wobei sich die Lufteinlassschlitze im Wesentlichen über den Umfang des Lüfters (38) erstrecken und die Luftauslassschlitze (52) sich zwischen einem Boden (56) des Gehäuses (10) und der Unterseite (48) des Kühlkörpers (46) erstrecken.

13. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
zwei oder mehrere der Bauteile Kühlkörper (46), Optikplatte (60), Peltier-Kühlelement (66), Metallplatte (72) mittels einer Wärmeleitpaste miteinander verbunden sind.

14. Vorrichtung zur Bestimmung der Konzentration zumindest eines Gases in einem Probengasstrom mittels Infrarotabsorptionsspektroskopie nach einem der vorhergehenden Ansprüche,
**dadurch gekennzeichnet, dass**
die Infrarotstrahlungsquelle (12) ein Quantenkaskadenlaser ist.

15. Verfahren zur Bestimmung der Konzentration zumindest eines Gases in einem Probengasstrom mittels Infrarotabsorptionsspektroskopie mittels einer Vorrichtung gemäß einem der vorhergehenden Ansprüche, bei dem die Strahlung der Infrarotstrahlungsquelle (12) in die Analysezelle (16) geleitet wird, die von dem Probengasstrom durchströmt wird, woraufhin mittels des Detektors (22) ein Absorptionsspektrum der aus der Analysezelle (16) austretenden Strahlung ermittelt wird und in einer Recheneinheit (37) aus dem Absorptionsspektrum die Konzentration eines Gases im Probengasstroms berechnet wird, wobei die Infrarotstrahlungsquelle (12) oder der Detektor (22) mittels des Peltier-Kühlelementes (66) gekühlt wird,
**dadurch gekennzeichnet, dass**
die warme Seite (68) des Peltier-Kühlelementes (66) mittels des drehzahlgeregelten Lüfters (38) zumindest indirekt gekühlt wird.

16. Verfahren zur Bestimmung der Konzentration zumindest eines Gases in einem Probengasstrom mittels Infrarotabsorptionsspektroskopie nach Anspruch 15,
**dadurch gekennzeichnet, dass**
die Drehzahl des Lüfters (38) durch Änderung eines Pulsweitenmodulations-Signals geregelt wird.

17. Verfahren zur Bestimmung der Konzentration zumindest eines Gases in einem Probengasstrom mittels Infrarotabsorptionsspektroskopie nach einem der Ansprüche 15 oder 16,
**dadurch gekennzeichnet, dass**
mittels des Lüfters (38) Umgebungsluft entlang des mit dem Peltier-Element (66) wärmeleitend verbundenen Kühlkörpers (46) gefördert wird.

18. Verfahren zur Bestimmung der Konzentration zumindest eines Gases in einem Probengasstrom mittels Infrarotabsorptionsspektroskopie nach einem der Ansprüche 15 bis 17,
**dadurch gekennzeichnet, dass**
der Kühlkörper (46) auf einen konstanten Wert zwischen 30°C und 50°C geregelt wird, insbesondere auf 40°C geregelt wird.

19. Verfahren zur Bestimmung der Konzentration zumindest eines Gases in einem Probengasstrom mittels Infrarotabsorptionsspektroskopie nach einem der Ansprüche 15 bis 18,
**dadurch gekennzeichnet, dass**
die Bestromung des Peltier-Kühlelementes (66) im Wesentlichen konstant ist.

20. Verfahren zur Bestimmung der Konzentration zumindest eines Gases in einem Probengasstrom mittels Infrarotabsorptionsspektroskopie nach Anspruch 19,
**dadurch gekennzeichnet, dass**
die Bestromung des Peltier-Kühlelementes (66) so eingestellt wird, dass zwischen der warmen Seite (68) und der kalten Seite (70) des Peltier-Kühlelementes (66) eine konstante Temperaturdifferenz von 20 K bis 40K anliegt.

## Claims

1. A device for determining the concentration of at least one gas in a sample gas flow by means of infrared absorption spectroscopy, comprising
an analysis cell (16) and an infrared radiation source (12) the radiation of which is adapted to be guided through the analysis cell (16),
a device through which a sample gas flow can be conducted into said analysis cell (16),
a detector (22) via which an absorption spectrum arising in said analysis cell (16) is adapted to be measured,
a heat sink (46) and a Peltier cooling element (66) having a hot side (68) and a cold side (70), wherein said cold side (70) is in thermally conductive contact with said infrared radiation source (12) or said detector (22) and said hot side is in thermally conductive contact with the heat sink (46),
**characterized in that**
said device comprises a speed-regulated fan (38) by which the heat sink (46) is cooled.

2. The device for determining the concentration of at least one gas in a sample gas flow by means of infrared absorption spectroscopy according to claim 1,
**characterized in that**
the rotational speed regulation of the fan (38) is effected by means of pulse width modulation.

3. The device for determining the concentration of at least one gas in a sample gas flow by means of infrared absorption spectroscopy according to any one of claims 1 or 2,
**characterized in that**
the infrared radiation source (12) is arranged at a metal plate (72) which is connected in a thermally conductive manner with the cold side (70) of the Peltier cooling element (66).

4. The device for determining the concentration of at least one gas in a sample gas flow by means of infrared absorption spectroscopy according to any one of the preceding claims,
**characterized in that**
a temperature sensor (81) is arranged to measure a temperature which essentially corresponds to the temperature at the hot side (68) of the Peltier cooling element (66), wherein said temperature sensor (81) is electrically connected with an electronic computing unit (37) of the fan (38).

5. The device for determining the concentration of at least one gas in a sample gas flow by means of infrared absorption spectroscopy according to any one of the preceding claims,
**characterized in that**
another temperature sensor (80) is arranged to measure a temperature which essentially corresponds to the temperature at the cold side (70) of the Peltier cooling element (66), wherein said temperature sensor (80) is electrically connected with an electronic regulating unit (82) of the Peltier cooling element (66).

6. The device for determining the concentration of at least one gas in a sample gas flow by means of infrared absorption spectroscopy according to any one of the preceding claims,
**characterized in that**
the infrared radiation source (12) comprises a laser chip (74) which is fastened by means of a holder (76) and is in thermally conductive contact with the metal plate (72).

7. The device for determining the concentration of at least one gas in a sample gas flow by means of infrared absorption spectroscopy according to any one of claims 3 to 6,
**characterized in that**
the metal plate (72) is a copper block.

8. The device for determining the concentration of at least one gas in a sample gas flow by means of infrared absorption spectroscopy according to any one of the preceding claims,
**characterized in that**
the heat sink (46) comprises ribs (50) at its lower side facing away from the Peltier cooling element (66).

9. The device for determining the concentration of at least one gas in a sample gas flow by means of infrared absorption spectroscopy according to any one of the preceding claims,
**characterized in that**
the optical elements (12, 18, 22, 24, 26, 28) are arranged outside the analysis cell (16) at an optical plate (60) which is arranged in a thermally conductive manner between the heat sink (46) and the hot side (68) of the Peltier cooling element (66).

10. The device for determining the concentration of at least one gas in a sample gas flow by means of infrared absorption spectroscopy according to claim 9,
**characterized in that**
the temperature sensor (81) is arranged to measure the temperature on the upper side (62) of the optical plate (60) in close vicinity to the Peltier cooling element (66).

11. The device for determining the concentration of at least one gas in a sample gas flow by means of infrared absorption spectroscopy according to any one of the preceding claims,
**characterized in that**
said device comprises a housing (10) allowing the fan (38) to draw ambient air from the surroundings of the housing, and in said housing (10) guiding bodies (44) are arranged which are configured to guide the air flow to the lower side (48) of the heat sink (46).

12. The device for determining the concentration of at least one gas in a sample gas flow by means of infrared absorption spectroscopy according to claim 11,
**characterized in that**
at the housing (10) at a first side wall (40) air inlet slots and at an opposite side wall (54) air outlet slots (52) are defined, wherein said air inlet slots essentially extend over the circumference of the fan (38) and said air outlet slots (52) extend between a bottom (56) of said housing (10) and the lower side (48) of the heat sink (46).

13. The device for determining the concentration of at least one gas in a sample gas flow by means of infrared absorption spectroscopy according to any one of the preceding claims,
**characterized in that**
two or more of the components heat sink (46), optical plate (60), Peltier cooling element (66), metal plate (72) are connected with each other by means of a thermally conductive paste.

14. The device for determining the concentration of at least one gas in a sample gas flow by means of infrared absorption spectroscopy according to any one of the preceding claims,
**characterized in that**
the infrared radiation source (12) is a quantum cascade laser.

15. A method for determining the concentration of at least one gas in a sample gas flow by means of infrared absorption spectroscopy with the aid of a device according to any one of the preceding claims, wherein the radiation of the infrared radiation source (12) is conducted into the analysis cell (16) through which the sample gas flow flows, whereupon an absorption spectrum of the radiation exiting said analysis cell (16) is determined by means of the detector (22), and in a computing unit (37) the concentration of a gas in the sample gas flow is calculated on the basis of the absorption spectrum, wherein said infrared radiation source (12) or said detector (22) is cooled by means of the Peltier cooling element (66),
**characterized in that**
a hot side (68) of said Peltier cooling element (66) is at least indirectly cooled by means of the speed-regulated fan (38).

16. The method for determining the concentration of at least one gas in a sample gas flow by means of infrared absorption spectroscopy according to claim 15,
**characterized in that**
the rotational speed of the fan (38) is regulated by a change of a pulse width modulation signal.

17. The method for determining the concentration of at least one gas in a sample gas flow by means of infrared absorption spectroscopy according to any one of claim 15 or 16,
**characterized in that**
by means of the fan (38) ambient air is delivered along the heat sink (46) connected in a thermally conductive manner with the Peltier element (66).

18. The method for determining the concentration of at least one gas in a sample gas flow by means of infrared absorption spectroscopy according to any one of claims 15 to 17,
**characterized in that**
the heat sink (46) is regulated to a constant value ranging between 30 °C and 50 °C, in particular to 40 °C.

19. The method for determining the concentration of at least one gas in a sample gas flow by means of infrared absorption spectroscopy according to any one of claims 15 to 18,
**characterized in that**
the current feed to the Peltier cooling element (66) is essentially constant.

20. The method for determining the concentration of at least one gas in a sample gas flow by means of infrared absorption spectroscopy according to claim 19,
**characterized in that**
the current feed to the Peltier cooling element (66) is adjusted such that between the hot side (68) and the cold side (70) of said Peltier cooling element (66) a constant temperature difference of 20 K to 40 K prevails.

## Revendications

1. Dispositif pour déterminer la concentration d'au moins un gaz dans un flux de gaz échantillon au moyen d'une spectroscopie d'absorption infrarouge avec une cellule s'analyse (16) et une source de rayonnement infrarouge (12), dont le rayonnement peut être guidé à travers la cellule d'analyse (16), un dispositif par lequel un flux de gaz échantillon peut être conduit dans la cellule d'analyse (16), un détecteur (22) par lequel un spectre d'absorption formé dans la cellule d'analyse (16) peut être mesuré, un puits de chaleur (46) et un élément de refroidissement Peltier (66) avec un côté chaud (68) et un côté froid (70), le côté froid (70) étant en contact thermiquement conducteur avec la source de rayonnement infrarouge (12) ou le détecteur (22) et le côté chaud étant en contact thermiquement conducteur avec le puits de chaleur (46), **caractérisé en ce que** le dispositif comprend un ventilateur à vitesse contrôlée (38), ledit ventilateur refroidissant le puits de chaleur (46)..

2. Dispositif pour déterminer la concentration d'au moins un gaz dans un flux de gaz échantillon au moyen d'une spectroscopie d'absorption infrarouge selon la revendication 1, **caractérisé en ce que** le contrôle de vitesse du ventilateur (38) est effectué par une modulation de largeur d'impulsion.

3. Dispositif pour déterminer la concentration d'au moins un gaz dans un flux de gaz échantillon au moyen d'une spectroscopie d'absorption infrarouge selon l'une des revendications 1 ou 2, **caractérisé en ce que** la source de rayonnement infrarouge (12) est disposée sur une plaque métallique (72) reliée de manière thermoconductrice au côté froid (70) dudit élément de refroidissement Peltier (66).

4. Dispositif de détermination la concentration d'au moins un gaz dans un flux de gaz échantillon au moyen d'une spectroscopie d'absorption infrarouge selon l'une quelconque des revendications précédentes, **caractérisé en ce qu'**un capteur de température (81) est disposé pour mesurer une température qui correspond essentiellement à la température du côté chaud (68) de l'élément de refroidissement Peltier (66), le capteur de température (81) étant connecté électriquement à une unité informatique électronique (37) du ventilateur (38).

5. Dispositif pour déterminer la concentration d'au moins un gaz dans un flux de gaz échantillon au moyen d'une spectroscopie d'absorption infrarouge selon l'une quelconque des revendications précédentes, **caractérisé en ce qu'**un autre capteur de température (80) est disposé pour mesurer une température qui correspond essentiellement à la température du côté froid (70) de l'élément de refroidissement Peltier (66), le capteur de température (80) étant connecté électriquement à une unité de commande électronique (82) dudit élément de refroidissement Peltier (66).

6. Dispositif pour déterminer la concentration d'au moins un gaz dans un flux de gaz échantillon au moyen d'une spectroscopie d'absorption infrarouge selon l'une quelconque des revendications précédentes, **caractérisé en ce que** la source de rayonnement infrarouge (12) comprend une puce laser (74) fixée par un support (76) et en contact thermoconducteur avec la plaque métallique (72).

7. Dispositif pour déterminer la concentration d'au moins un gaz dans un flux de gaz échantillon au moyen d'une spectroscopie d'absorption infrarouge selon l'une quelconque des revendications 3 à 6, **caractérisé en ce que** la plaque métallique (72) est un bloc de cuivre.

8. Dispositif pour déterminer la concentration d'au moins un gaz dans un flux de gaz échantillon au moyen d'une spectroscopie d'absorption infrarouge selon l'une quelconque des revendications précédentes, **caractérisé en ce que** le puits de chaleur (46) comprend des nervures (50) sur sa face inférieure (48) opposée à l'élément de refroidissement Peltier (66).

9. Dispositif pour déterminer la concentration d'au moins un gaz dans un flux de gaz échantillon au moyen d'une spectroscopie d'absorption infrarouge selon l'une quelconque des revendications précédentes, **caractérisé en ce que** les éléments optiques (12, 18, 22, 24, 26, 28) sont disposés à l'extérieur de la cellule d'analyse (16) sur une plaque optique (60), laquelle est disposée de manière conductrice de chaleur entre le puits de chaleur (46) et le côté chaud (68) de l'élément de refroidissement Peltier (66).

10. Dispositif pour déterminer la concentration d'au moins un gaz dans un flux de gaz échantillon au moyen d'une spectroscopie d'absorption infrarouge selon la revendication 9, **caractérisé en ce que** le capteur de température (81) est disposé pour mesurer la température sur le côté supérieur (62) de la plaque optique (60) à proximité immédiate de l'élément de refroidissement Peltier (66).

11. Dispositif pour déterminer la concentration d'au moins un gaz dans un flux de gaz échantillon au moyen d'une spectroscopie d'absorption infrarouge selon l'une quelconque des revendications précédentes, **caractérisé en ce que** le dispositif comprend un carter (10) permettant au ventilateur (48) d'aspirer de l'air ambiant de l'environnement du ventilateur (38), et que des corps de guidage (44) sont disposés dans le carter (10), qui son agencés pour guider le flux d'air vers la face inférieure (48) du puits de chaleur(46).

12. Dispositif pour déterminer la concentration d'au moins un gaz dans un flux de gaz échantillon au moyen d'une spectroscopie d'absorption infrarouge selon la revendication 11, **caractérisé en ce que** des fentes d'entrée d'air (52) sont formées dans le carter (10) dans une première paroi latérale (40) et des fentes de sortie d'air (52) sont formées dans une paroi latérale opposée (54), lesdites fentes d'entrée d'air s'étendant sensiblement sur la circonférence du ventilateur (38) et lesdites fentes de sortie d'air (52) s'étendant entre un fond (56) du carter (10) et la face inférieure (48) du puits de chaleur (46).

13. Dispositif pour déterminer la concentration d'au moins un gaz dans un flux de gaz échantillon au moyen d'une spectroscopie d'absorption infrarouge selon l'une quelconque des revendications précédentes, **caractérisé en ce que** deux ou plusieurs des composants puits de chaleur (46), plaque optique (60), élément de refroidissement Peltier (66), plaque métallique (72) sont reliés l'un à l'autre par une pâte thermique.

14. Dispositif pour déterminer la concentration d'au moins un gaz dans un flux de gaz échantillon au moyen d'une spectroscopie d'absorption infrarouge selon l'une quelconque des revendications précédentes, **caractérisé en ce que** la source de rayonnement infrarouge (12) est un laser à cascade quantique.

15. Procédé pour déterminer la concentration d'au moins un gaz dans un flux de gaz échantillon au moyen d'une spectroscopie d'absorption infrarouge au moyen d'un dispositif selon l'une quelconque des revendications précédentes, dans lequel le rayonnement provenant de la source de rayonnement infrarouge (12) est guidé dans la cellule d'analyse (16) à travers laquelle un flux de gaz échantillon s'écoule, après quoi, au moyen du détecteur (22), un spectre d'absorption du rayonnement sortant de la cellule d'analyse (16) est déterminé et la concentration d'un gaz dans le flux de gaz échantillon est calculée dans une unité de calcul (37) à partir du spectre d'absorption, la source de rayonnement infrarouge (12) ou le détecteur (22) étant refroidi par ledit élément de refroidissement Peltier (66), **caractérisé en ce que** le côté chaud (68) dudit élément de refroidissement Peltier (66) est au moins indirectement refroidi par ledit ventilateur à vitesse variable (38).

16. Procédé pour déterminer la concentration d'au moins un gaz dans un flux de gaz échantillon au moyen d'une spectroscopie d'absorption infrarouge selon la revendication 15, **caractérisé en ce que** la vitesse du ventilateur (38) est contrôlée en modifiant un signal de modulation de largeur d'impulsion.

17. Procédé pour déterminer la concentration d'au moins un gaz dans un flux de gaz échantillon au moyen d'une spectroscopie d'absorption infrarouge selon l'une des revendications 15 ou 16, **caractérisé en ce que** l'air ambiant est refoulé au moyen du ventilateur (38) le long du puits de chaleur (46) relié de manière thermiquement conductrice à l'élément Peltier (66).

18. Procédé pour déterminer la concentration d'au moins un gaz dans un flux de gaz échantillon par spectroscopie d'absorption infrarouge selon l'une des revendications 15 à 17, **caractérisé en ce que** le puits de chaleur (46) est réglé à une valeur constante comprise entre 30 °C et 50 °C, notamment 40 °C.

19. Procédé pour déterminer la concentration d'au moins un gaz dans un flux de gaz échantillon au moyen d'une spectroscopie d'absorption infrarouge selon l'une des revendications 15 à 18, **caractérisé en ce que** l'alimentation en courant dudit élément de refroidissement Peltier (66) est essentiellement constante.

20. Procédé pour déterminer la concentration d'au moins un gaz dans un flux de gaz échantillon au moyen d'une spectroscopie d'absorption infrarouge selon la revendication 19, **caractérisé en ce que** l'alimentation en courant dudit élément de refroidissement Peltier (66) est réglée de telle sorte qu'entre le côté chaud (68) et le côté froid (70) dudit élément de refroidissement Peltier (66) existe une différence de température constante de 20K à 40K.
